# EUROPÄISCHE PATENTANMELDUNG

(11) **EP 1 003 045 A2**
(43) Veröffentlichungstag der Anmeldung: **24.05.2000**
(21) Anmeldenummer: 99121223.4
(22) Anmeldetag: 23.10.1999
(51) Int. Cl.: G01R 19/00, G01R 1/067

(54) **Spannungsmessschaltung**

(30) Priorität: 18.11.1998 DE 19853099
(71) Anmelder: ROBERT BOSCH GMBH, 70442 Stuttgart (DE)
(72) Erfinder: Etzold, Peter, 73061 Ebersbach (DE)

(57) **Zusammenfassung**

Es wird eine Spannungsmeßschaltung (13) vorgeschlagen, die zum Abtrennen eines Gleichspannungsanteils (Udc) einer Meßspannung (Ux) einen CR-Hochpaß (C,Re) enthält. Zur Verkürzung der Einschwingzeit des CR-Hochpasses (C,Re) ist die Parallelschaltung eines Ladewiderstands (Rs) zum Widerstand (Re) des CR-Hochpasses (C,Re) vorgesehen.

## Beschreibung

### Stand der Technik

Die Erfindung geht aus von einer Spannungsmeßschaltung nach der Gattung des unabhängigen Anspruchs.
Zur Messung eines Wechselspannungsanteils einer Spannungsquelle, der einem Gleichspannungsanteil überlagert ist, wird der Gleichspannungsanteil mittels eines Hochpaßfilters vom zu messenden Wechselspannungsanteil getrennt. Als Hochpaßfilter ist beispielsweise ein einfacher CR-Hochpaß geeignet. Solche Schaltungen finden sich beispielsweise im Eingangsteil eines Oszilloskops. In Abhängigkeit von der Zeitkonstante des CR-Hochpasses kann es nach Aufschalten der zu messenden Spannung mehrere Sekunden dauern, bis der CR-Hochpaß eingeschwungen ist.

Der Erfindung liegt die Aufgabe zugrunde, eine Spannungsmeßschaltung anzugeben, die eine schnelle Erfassung eines Wechselspannungsanteils bei vorhandenem Gleichspannungsanteil ermöglicht.

Die Aufgabe wird durch die im unabhängigen Anspruch angegebenen Merkmale gelöst.

### Vorteile der Erfindung

Die erfindungsgemäße Spannungsmeßschaltung weist den Vorteil auf, daß mit einfachen schaltungstechnischen Mitteln ein schnelles Einschwingen eines CR-Hochpasses erreicht wird. Erfindungsgemäß ist ein Schalter vorgesehen, der dem Widerstand des CR-Hochpasses einen Ladewiderstand parallel schaltet.

Mit der erfindungsgemäßen Maßnahme wird erreicht, daß der Kondensator des CR-Hochpasses über den Ladewiderstand rasch wenigstens näherungsweise auf den Gleichspannungsanteil der Meßspannung aufgeladen wird. Der raschen Aufladung entspricht ein schnelles Einschwingen in einen stabilen Arbeitspunkt.

Vorteilhafte Ausgestaltungen und Weiterbildungen der erfin-dungsgemäßen Spannungsmeßschaltung ergeben sich aus abhängigen Ansprüchen.

Eine einfache Ausgestaltung sieht vor, den Schalter mit einem manuell eingegebenen Schließsignal zu betätigen. Vorteilhafterweise ist ein von einem Startsignal angestoßener Zeitgeber vorgesehen, der das Schließsignal für eine festgelegte Zeit bereitstellt.

Gemäß einer einfachen Ausgestaltung kann das Startsignal manuell vorgegeben werden. Vorteilhafterweise wird das Startsignal von einem Komparator bereitgestellt, der die Meßspannung mit einer Referenzspannung vergleicht.

Eine vorteilhafte Ausgestaltung sieht vor, daß die vom Zeitgeber vorgegebene Zeit wenigstens näherungsweise auf einen Wert festegelegt ist, der sich ergibt aus dem Produkt der Kapazität des Kondensators des CR-Hochpasses und dem Wert des Ladewiderstands, multipliziert mit dem Faktor 12.

Die erfindungsgemäße Spannungsmeßschaltung ist insbesondere geeignet für eine Messung an einer Spannungsquelle, die einen hohen Gleichspannungsanteil im Vergleich zum überlagerten Wechselspannungsanteil aufweist. Eine derartige Spannungsquelle ist beispielsweise eine in einem Kraftfahrzeug eingebaute Batterie. Die erfindungsgemäße Spannungsmeßschaltung kann deshalb vorzugsweise verwendet werden zum Messen des Wechselspannungsanteils an einer derartigen Batterie. Ein solcher Wechselspannungsanteil kann vorteilhaft während eines Batterietests durch entsprechende Belastung vorgegeben werden, um den Wechselspannungsinnenwiderstand unter Last zu ermitteln.

Weitere vorteilhafte Weiterbildungen und Ausgestaltungen der erfindungsgemäßen Spannungsmeßschaltung ergeben sich aus weiteren abhängigen Ansprüchen und aus der folgenden Beschreibung.

### Zeichnung

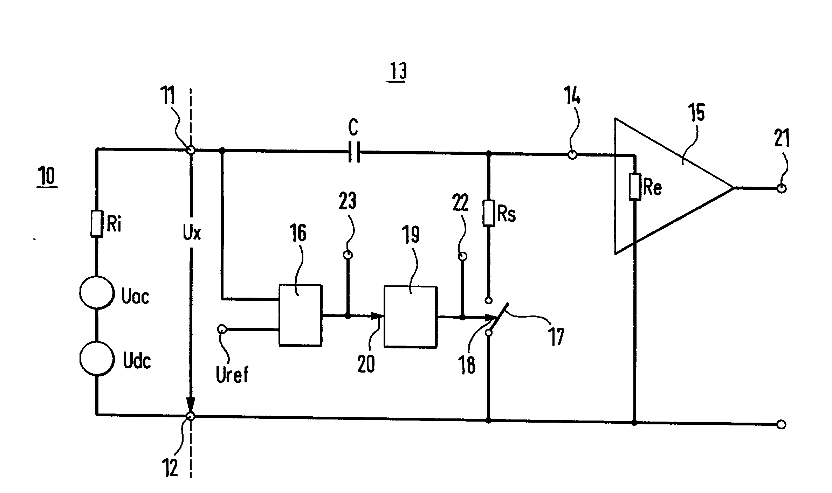

Die Figur zeigt ein Ausführungsbeispiel einer erfindungsgemäßen Spannungsmeßschaltung.

Die Figur zeigt eine Spannungsquelle 10, die einen ersten Anschluß 11 und einen zweiten Anschluß 12 aufweist. Zwischen dem ersten und zweiten Anschluß 11, 12 liegt die zu messende Spannung Ux der Spannungsquelle 10.

Das Ersatzschaltbild der Spannungsquelle 10 enthält eine Gleichspannungsquelle Udc, eine Wechselspannungsquelle Uac sowie einen Innenwiderstand Ri.

Strichliniert abgetrennt von der Spannungsquelle 10 ist ein Blockschaltbild der erfindungsgemäßen Spannungsmeßschaltung 13 gezeigt, die an den ersten und zweiten Anschluß 11, 12 der Spannungsquelle 10 anzuschließen ist. Der erste Anschluß 11 ist mit einem Komparator 16 sowie über einen Kondensator C mit einem Eingang 14 eines Meßverstärkers 15 verbunden. Der Meßverstärker 15 weist einen Eingangswiderstand Re auf, der am zweiten Anschluß 12 der Spannungsquelle 10 liegt. Parallel zum Eingangswiderstand Re ist mittels eines Schalters 17 ein Ladewiderstand Rs schaltbar.

Der Schalter 17 wird von einem Schließsignal 18 angesteuert, das ein Zeitgeber 19 abgibt oder das ein manuell ausgelöstes Schließsignal 22 sein kann. Der Zeitgeber 19 wird von einem Startsignal 20 angestoßen, das der Komparator 16 bereitstellt, der die Meßspannung Ux mit einer Referenzspannung Uref vergleicht, oder das ein manuell ausgelöstes Startsignal 23 sein kann.

An einem Ausgang 21 des Meßverstärkers 15 kann der Wechselspannungsanteil Uac, der in der Meßspannung Ux enthalten ist, gegebenenfalls verstärkt, abgegriffen werden.

Die erfindungsgemäße Spannungsmeßschaltung 13 arbeitet folgendermaßen:

Die erfindungsgemäße Spannungsmeßschaltung 13 ermöglicht die schnelle Erfassung des Wechselspannungsanteils Uac, der in der Meßspannung Ux enthalten ist, dem der Gleichspannungsanteil Udc überlagert ist, insbesondere kurz nach dem Anklemmen der erfindungsgemäßen Spannungsmeßschaltung 13 an den ersten und zweiten Anschluß 11, 12 der Spannungsquelle 10.

Ein Beispiel einer Spannungsquelle 10, die den Gleichspannungsanteil Udc sowie den Wechselspannungsanteil Uac aufweist, ist eine Batterie, insbesondere Starterbatterie oder Antriebsbatterie für ein Kraftfahrzeug, deren Wechselspannungsinnenwiderstand unter Last ermittelt werden soll. Der Wechselspannungsanteil Uac wird durch eine Wechselstrombeaufschlagung der Batterie verursacht. Der Wechselspannungsanteil Uac entsteht in Wechselwirkung mit dem Innenwiderstand Ri der Spannungsquelle 10.

Die erfindungsgemäße Spannungsmeßschaltung 13 ermöglicht eine erheblich raschere Erfassung des Wechselspannungsanteils Uac gegenüber herkömmlichen Schaltungen. Der Wechselspannungsanteil Uac gelangt über den Kondensator C an den Eingang 14 des Meßverstärkers 15. Der Kondensator C und der Innenwiderstand Re des Meßverstärkers 15 bilden einen CR-Hochpaß C, Re, der eine von den Bauteiledaten bestimmte Zeitkonstante aufweist. Ein stabiler Arbeitspunkt ist dann erreicht, wenn der Kondensator C über den Eingangswiderstand Re des Meßverstärkers 15, der Teil des CR-Hochpasses ist, den Kondensator C auf den Gleichspannungsanteil Udc der Spannungsquelle 10 aufgeladen hat. Im stationären Zustand tritt am Meßverstärker 15 nur noch der Wechselspannungsanteil Uac der Spannungsquelle 10 auf.

Erfindungsgemäß ist eine Abkürzung des Ladevorgangs des Kondensators C dadurch vorgesehen, daß dem Widerstand des CR-Hochpasses C, Re der Ladewiderstand Rs parallel geschaltet wird.

Eine einfache Möglichkeit ist die Bereitstellung des Schließsignals 18 durch das manuell ausgelöste Schließsignal 22, das eine Bedienperson veranlaßt. Der Zeitpunkt der Spannungsmessung ist beliebig festlegbar.

Eine andere Möglichkeit sieht den Einsatz des Zeitgebers 19 vor, der vom Startsignal 20 angestoßen wird. Aufgrund des Startsignals 20 startet der Zeitgeber 19 die Bereitstellung des Schließsignals 18 für die vom Zeitgeber 19 vorgegebene Zeit.

Eine einfache Möglichkeit ist die Bereitstellung des Startsignals 19 durch das manuell ausgelöste Startsignal 23, das eine Bedienperson veranlaßt. Der Beginn der Spannungsmessung ist somit wieder beliebig festlegbar.

Eine andere Möglichkeit sieht den Einsatz des Komparators 16 vor. Der Komparator 16 vergleicht die Meßspannung Ux mit der vorgegebenen Referenzspannung Uref. Die Referenzspannung Uref wird beispielsweise auf einen Wert festgelegt, der ein Erkennen der Kontaktierung der erfindungsgemäßen Spannungsmeßschaltung 13 mit den beiden Anschlüssen 11, 12 der Spannungsquelle 10 ermöglicht. Gegebenenfalls kann eine Glättung des Wechselspannungsanteils Uac und/oder eine Gleichrichtung des Wechselspannungsanteils Uac vor der Zuführung an den Komparator 16 zweckmäßig sein. Erforderlich ist dies nicht, sofern insgesamt der Betrag der Meßspannung Ux zu irgend einem Zeitpunkt den Wert der Referenzspannung Uref übersteigt, so daß der Komparator 16 das Startsignal 20 bereitstellen kann. Im Extremfall kann der Wert der Referenzspannung Uref bis auf Null Volt reduziert werden. Im gezeigten Ausführungsbeispiel könnte dann der Schaltungspunkt, der mit Uref bezeichnet ist, unmittelbar mit dem zweiten Anschluß 12 der Spannungsquelle 10 verbunden werden.

Das Startsignal 20 signalisiert der erfindungsgemäßen Spannungsmeßschaltung 13 unmittelbar das Vorhandensein einer Meßspannung Ux und sorgt sofort für das Schließen des Schalters 17. Der Wechselspannungsanteil Uac ist nach Kontaktierung der erfindungsgemäßen Spannungsmeßschaltung 13 und nach Ablauf der vom Zeitgeber 19 festgelegten Zeit sofort mit hoher Genauigkeit erfassbar.

Eine zweckmäßige Festlegung der vom Zeitgeber 19 festgelegten Zeit ergibt sich aus dem Produkt der Kapazität des Kondensators C des CR-Hochpasses C, Re und dem Wert des Ladewiderstands Rs, multipliziert mit dem Faktor 10. Mit dieser Bemessung ist ein tragfähiger Kompromiß möglich zwischen der geforderten Genauigkeit beim Erfassen des Wechselspannungsanteils Uac und der Zeit, innerhalb der die Genauigkeit erreicht sein soll.

Ein Verwendungsbeispiel veranschaulicht den Zeitgewinn gegenüber einer herkömmlichen Spannungsmeßschaltung und gibt Anhaltspunkte für die Dimensionierung der erfindungsgemäßen Spannungsmeßschaltung 13. Soll beispielsweise ein Wechselspannungssignal, dessen Amplitude 8 mV beträgt und eine Frequenz von beispielsweise 25 Hz aufweist aus einer 12-Volt-Batterie ausgekoppelt und verstärkt werden, wobei das Ausgangssignal in weniger als 200 Millisekunden nach Anklemmen der Batterie auf 1 % von 8 mV eingeschwungen sein soll, so ist folgende Dimensionierung denkbar: C = 10 Mikrofarad, Re = 75 Kiloohm und Rs = 1 Kiloohm. Die dem Zeitgeber 19 vorzugebende Zeit beträgt dann mindestens 120 Millisekunden. Ohne die erfindungsgemäß vorgesehenen Maßnahmen müßten etwa 9 Sekunden gewartet werden bis der Einschaltimpuls auf 1 % von 8 mV abgeklungen ist.
Der Innenwiderstand Ri der Batterie liegt typisch bei 10 Milliohm.

In einer praktischen Umsetzung der Erfindung ist vorzugsweise ein Mikroprozessor vorgesehen, der sofort nach dem Anklemmen der Batterie, aus der die gesamte Schaltung auch mit der benötigten elektrischen Hilfsenergie versorgt werden kann, das Schließen des Schalters 17 veranlaßt. Bis zum Zeitpunkt, zu dem eine Bedienperson den Batterietest auslöst, ist der Einschwingvorgang im allgemeinen abgeschlossen.

## Patentansprüche

1. Spannungsmeßschaltung (13) mit einem CR-Hochpaß (C, Re), der zum Abtrennen eines Gleichspannungsanteils (Udc) einer Meßspannung (Ux) vorgesehen ist, dadurch gekennzeichnet, daß ein Schalter (17) vorgesehen ist, der dem Widerstand (Re) des CR-Hochpasses (C, Re) einen Ladewiderstand (Rs) parallel schaltet.

2. Spannungsmeßschaltung (13) nach Anspruch 1, dadurch gekennzeichnet, daß der Schalter (17) von einem manuell ausgelösten Schließsignal (22) beaufschlagt ist.

3. Spannungsmeßschaltung (13) nach Anpruch 1 oder 2, dadurch gekennzeichnet, daß ein von einem Startsignal (20) angestoßener Zeitgeber (19) vorgesehen ist, der das Schließsignal (18) für eine festgelegte Zeit bereitstellt.

4. Spannungsmeßschaltung (13) nach Anspruch 3, dadurch gekennzeichnet, daß das Startsignel (20) ein manuell ausgelöstes Startsignal (23) ist.

5. Spannungsmeßschaltung (13) nach Anspruch 3, dadurch gekennzeichnet, daß das Startsignal (20) von einem Komparator (16) bereitgestellt ist, der die Meßspannung (Ux) mit einer Referenzspannung (Uref) vergleicht.

6. Spannungsmeßschaltung nach einem der Ansprüche 1 bis 5, dadurch gekennzeichnet, daß die Zeit des Zeitgebers (19) auf wenigstens näherungsweise einen Wert festgelegt ist, der sich ergibt aus dem Produkt der Kapazität des Kondensators (C) des CR-Hochpasses (C,Re) und dem Wert des Ladewiderstands (Rs), multipliziert mit dem Faktor 12.

7. Schaltung nach Anspruch 1 oder 3 oder 5, dadurch gekennzeichnet, daß das Schalten des Schalters (17) mit dem Beaufschlagen der Spannungsmeßschaltung (13) mit der Meßspannung (Ux) vorgesehen ist.

8. Schaltung nach einem der vorhergehenden Ansprüche, dadurch gekennzeichnet, daß aus der Meßspannung (Ux) die Spannungsversorgung der Spannungsmeßschaltung (13) abgeleitet ist.

9. Verwendung der Schaltung nach einem der vorhergehenden Ansprüche zum Messen des Wechselspannungsanteils (Uac), der an einer Batterie auftritt, die mit einem Wechselstrom belastet ist.
